# EUROPÄISCHE PATENTSCHRIFT

(11) **EP 0 667 094 B1**
(45) Veröffentlichungstag und Bekanntmachung des Hinweises auf die Patenterteilung: **15.01.1997**
(21) Anmeldenummer: 93921807.9
(22) Anmeldetag: 08.10.1993
(51) Int. Cl.: H05K 9/00, H01R 23/68

(54) **RÜCKWANDLEITERPLATTE FÜR EINEN BAUGRUPPENRAHMEN**
BACKPLANE PRINTED CIRCUIT BOARD FOR A MODULE FRAME
CARTE DE CIRCUIT IMPRIME DE FOND DE PANIER POUR UN CADRE DE MODULE

(30) Priorität: 29.10.1992 DE 4236593
(43) Veröffentlichungstag der Anmeldung: 16.08.1995
(73) Patentinhaber: SIEMENS AKTIENGESELLSCHAFT, 80333 München (DE)
(72) Erfinder: HEITZIG, Claus-Peter, D-85235 Pfaffenhofen (DE); THALHAMMER, Erich, D-80807 München (DE)
(86) Internationale Anmeldenummer: DE9300956
(87) Internationale Veröffentlichungsnummer: WO9410824

(56) Entgegenhaltungen:
- EP-A- 0 459 356
- EP-A- 0 519 767
- WO-A-91/06202
- DE-A- 3 834 182
- US-A- 4 571 014
- EDN ELECTRICAL DESIGN NEWS. Bd. 31, Nr. 14 , Juli 1986 , NEWTON, MASSACHUSETTS US Seiten 222 - 228 TOM ORMOND 'Backplanes play a crucial role in high-speed systems'

## Beschreibung

Die Erfindung bezieht sich auf eine mehrlagige Leiterplatte für eine Rückwand eines Baugruppenrahmens insbesondere in einer Telekommunikationsanlage, wobei die Leiterplatte mit einer weitgehend geschlossenen Schirmlage und mit Durchkontaktierungen versehen ist, die Leiterbahnen von verschiedenen inneren Signallagen miteinander verbinden. Derartige geschirmte Rückwandleiterplatten werden zunehmend in der modernen breitbandigen Vermittlungstechnik mit Übertragungsraten von z.B. 140 Mbit/s und mit internen Arbeitsfrequenzen bis zu 850 Mbit/s verwendet. Dabei ist es erforderlich, die Leiterbahnen von unterschiedlichen inneren Signallagen miteinander zu verbinden. Dies geschieht mittels Durchkontaktierungen, die nach dem Zusammenfügen der einzelnen Lagen erzeugt werden und die demzufolge von außen zugänglich sein müssen. Das bedeutet, daß die Durchkontaktierungen gegenüber den äußeren Schirmlagen isoliert sein müssen, so daß sich an diesen Stellen hinsichtlich der elektromagnetischen Schirmung Undichtigkeiten ergeben, die sich besonders stark bei sehr hohen Frequenzen auswirken.

Um diese Undichtigkeiten zu vermeiden, ist es bekannt, zunächst die inneren Lagen mit den Durchkontaktierungen fertig zu stellen und anschließend die äußeren Schirmlagen aufzubringen, die die Durchkontaktierungen überdecken. Da dabei die aufwendigen Arbeitsprozesse der Herstellung einer mehrlagigen Leiterplatte zweimal durchgeführt werden müssen, führt dies zu einem erheblichen Kostenaufwand.

Ferner ist es durch die WO-A-91/06202 bekannt, Leiterplatten mit äußeren Schirmlagen zu versehen, die teilweise für Durchkontaktierungen durchbrochen sind. Diese sind auf begrenzte Felder konzentriert und mit Schirmhauben überdeckt, die an ihren Rändern mit der Schirmlage elektrisch verbunden sind.

Der Erfindung liegt die Aufgabe zugrunde, den Flächenverbrauch für die Durchkontaktierungen zu verringern und die Schirmung der Durchkontaktierungen ohne Qualitätseinbußen mit geringerem Aufwand zu realisieren.

Diese Aufgabe wird durch die Erfindung gemäß Anspruch 1 gelöst. Über die außerhalb der Steckverbinder gelegenen Felder mit den Durchkontaktierungen können z.B. Schirmhauben gelegt werden, die mit den Schirmlagen kontaktiert sind und die Durchkontaktierungen überdecken. Durch das Zusammenfassen der Durchkontaktierungen in verschiedenen Gruppen kann die Anzahl der Schirmeinrichtungen gering gehalten werden. Durch Standardisierungen der Lochbilder für die Durchkontaktierungen in verschiedenen Abstufungen ist es möglich, standardisierte Schirmhauben zu verwenden, die kostengünstig vorgefertigt werden können.

Die um die Steckverbinder umlaufenden Schirmbleche sind z.B. mit einem Schirmgehäuse eines Kabel steckers kontaktierbar und damit elektromagnetisch verschließbar. Durch das Verlegen der Durchkontaktierungen in den Bereich innerhalb der Schirmbleche können sämtliche zusätzlichen Schirmmaßnahmen für die Durchkontaktierungen entfallen. Die Durchkontaktierungen, die direkt unter die Schirmbleche zu liegen kommen können z.B. für niedrig frequente Leiter benutzt werden, die hinsichtlich ihres Störungsverhaltens wenig kritisch sind. Die Durchkontaktierungen sind durch die Erfindung vorzugsweise in Rasterpunktenreihen der Leiterplatte angeordnet, die für Steckkontakte ohnehin nicht nutzbar sind. Damit wird erreicht, daß für diese Durchkontaktierungen keine zusätzliche Fläche auf der Leiterplatte verbraucht wird.

Vorteilhafte Weiterbildungen der Erfindung sind in den Ansprüchen 2 und 3 gekennzeichnet.

Durch die Weiterbildung nach Anspruch 2 ist es möglich, die Schirmbleche engmaschig mit den Schirmlagen der Leiterplatte zu verbinden und dennoch die verbleibenden Zwischenräume für die Durchkontaktierungen zu nutzen.

Durch die Weiterbildung nach Anspruch 3 wird der Raum zwischen den Schirmblechen und den Steckkontaktteilen vollständig für die Durchkontaktierungen genutzt. Dieser Bereich ist üblicherweise für Steckkontaktteile nicht nutzbar, da sich an diesen Stellen Seitenwände von Steckergehäusen befinden.

Im folgenden wird die Erfindung anhand eines in der Zeichnung dargestellten Ausführungsbeispiels näher erläutert.

Es zeigen:
- Fig. 1: schematisiert einen Querschnitt durch eine mehrlagige Leiterplatte mit Steckkontaktteilen, Schirmhauben und Schirmblechen,
- Fig. 2: eine partielle Draufsicht auf die Leiterplatte nach Figur 1.

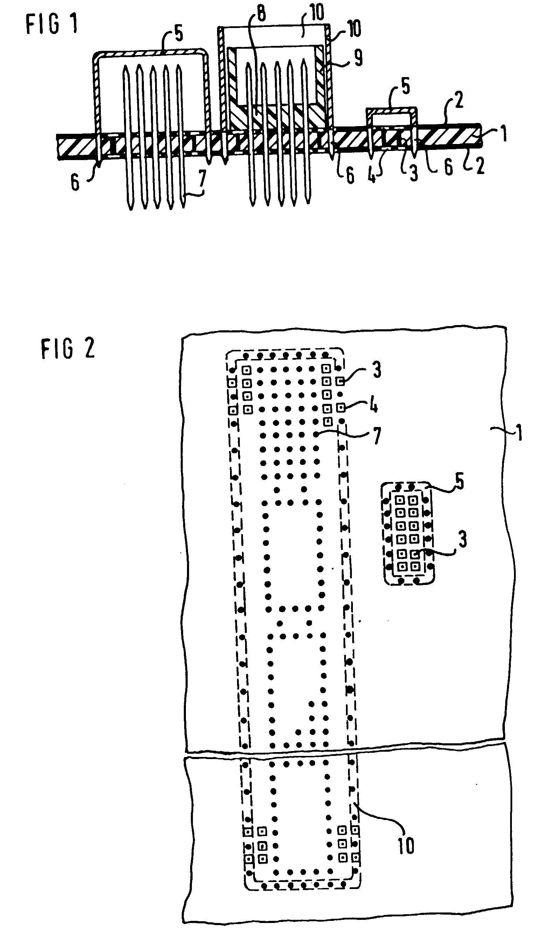

Nach den Figuren 1 und 2 ist eine mehrlagige Leiterplatte 1 einer Rückwand eines Baugruppenrahmens mit nicht näher dargestellten inneren Signal lagen und beidseitigen äußeren Schirmlagen 2 versehen, die die Leiterplatte großflächig überdecken. Leiterbahnen der unterschiedlichen Signallagen werden mittels Durchkontaktierungen 3 miteinander verbunden. Diese müssen aus fertigungstechnischen Gründen von beiden Seiten zugänglich sein. Sie sind gegenüber den Schirmlagen 2 durch Freiätzungen 4 in diesen elektrisch isoliert. Die Durchkontaktierungen sind in Reihen bzw. Doppelreihen gruppenweise zusammengefaßt und durch Schirmhauben 5 rundum überdeckt. Die Schirmhauben 5 sind mit stiftartigen Vorsprüngen 6 in Bohrungen der Leiterplatte 1 eingepreßt und mit den Schirmlagen 2 kontaktiert.

In die Leiterplatte 1 sind stiftartige Steckkontaktteile 7 eingepreßt, auf die z.B. Steckbaugruppen aufsteckbar sind. Sie ragen durch die Leiterplatte 1 bis zu deren Rückseite hindurch, auf der die Schirmhauben 5 aufgesteckt sind. Ein Teil der Steckkontaktteile 7 ist rückseitig mit einem Stekkergehäuse 8 versehen, daß entlang seiner Seitenwände 9 von senkrecht zur Leiterplatte 1 stehenden Schirmblechen 10 umgeben ist.

Die Schirmbleche 10 und die Schirmhaube 5 sind in Figur 2 der Übersichtlichkeit halber gestrichelt dargestellt. Sie umschließen die Steckkontaktteile 7 mit einer Zwischenreihe Abstand, in der die Durchkontaktierungen innerhalb der Seitenwände 9 in durchgehenden Reihen angeordnet sind. Die Schirmbleche 10 sind z.B. mit einem Schirmmantel eines aufsteckbaren Kabelsteckers kontaktierbar und werden durch diesen elektromagnetisch verschlossen. Die Schirmbleche sind ebenfalls mit den stiftartigen Vorsprüngen 6 versehen, mit denen sie in die Leiterplatte 1 eingepreßt sind.

## Patentansprüche

1. Mehrlagige Leiterplatte (1) insbesondere in einer Telekommunikationsanlage, wobei die Leiterplatte (1) mit einer weitgehend geschlossenen Schirmlage (2) und mit Durchkontaktierungen (3) versehen ist, die Leiterbahnen von verschiedenen inneren Signallagen miteinander verbinden und bis in die äußere Schirmlage (2) reichen, gegenüber der sie z.B. durch Freiätzungen (4) isoliert sind, wobei die Durchkontaktierungen (3) auf begrenzte Felder der Leiterplatte (1) konzentriert und diese Felder durch Schirmeinrichtungen überdeckbar sind
**dadurch gekennzeichnet,**
daß zumindest die Hochfrequenz führenden Durchkontaktierungen (3) gruppenweise auf die begrenrsen Felder konzentriert sind,
daß die Leiterplatte (1) als Rückwandverdrahtungsplatte eines Baugruppenrahmens ausgebildet ist, daß auf der rückseitig Steckverbinder (7, 8) für aufsteckbare Kabelstecker angebracht sind, daß die Kabelstecker von einem Schirmgehäuse umschlossen sind, daß die Steckverbinder (7, 8) von seitlichen Schirmblechen (10) umgeben sind, die mit der Schirmlage (2) und dem Schirmgehäuse kontaktierbar sind, und daß zumindest eine Teilmenge der Durchkontaktierungen (3) zwischen den Steckkontaktteilen (7) des Steckverbinders und den Schirmblechen (10) oder unter diesen Schirmblechen angeordnet sind.

2. Leiterplatte nach Anspruch 1,
**dadurch gekennzeichnet,**
daß die Schirmbleche (10) mit stiftartigen Vorsprüngen (6) in Bohrungen der Leiterplatte (1) einpreßbar sind und daß die Durchkontaktierungen (3) zwischen diesen angeordnet sind.

3. Leiterplatte nach Anspruch 1 oder 2,
**dadurch gekennzeichnet,**
daß zwischen den Steckkontaktteilen (7) und den Schirmblechen (10) liegende Reihen von Rasterpunkten der Leiterplatte (1) durchgehend mit den Durchkontaktierungen (3) belegt sind.

## Claims

1. Multilayer printed circuit board (1), in particular in a telecommunications system, the printed circuit board (1) being provided with a largely closed screening layer (2) and with plated-through holes (3) which interconnect conductor tracks of different inner signal layers and extend right into the outer screening layer (2), with respect to which they are insulated, for example, by means of clearance holes (4), the plated-through holes (3) being concentrated on limited zones of the printed circuit board (1) and it being possible to cover said zones by means of screening devices, characterized in that at least the radio-frequency-carrying plated-through holes (3) are concentrated in groups on the limited zones, in that the printed circuit board (1) is designed as a wiring backplane of a mounting rack, in that plug connectors (7, 8) for plug-on cable plugs are attached to the rear side of said wiring backplane, in that the cable plugs are enclosed by a screening housing, in that the plug connectors (7, 8) are surrounded by lateral screening metal sheets (10) which can make contact with the screening layer (2) and the screening housing, and in that at least some of the plated-through holes (3) are arranged between the plug contact parts (7) of the plug connector and the screening metal sheets (10) or underneath the said screening metal screens.

2. Printed circuit board according to Claim 1, characterized in that the screening metal sheets (10) can be pressed by pin-like projections (6) into holes in the printed circuit board (1), and in that the plated-through holes (3) are arranged between said holes.

3. Printed circuit board according to Claim 1 or 2, characterized in that rows, located between the plug contact parts (7) and the screening metal sheets (10), of grid points of the printed circuit board (1) are completely occupied by the plated-through holes (3).

## Revendications

1. Carte (1) à circuit imprimé multicouche, notamment dans une installation de télécommunication, la carte (1) à circuit imprimé ayant une couche (2) de blindage fermée dans une large mesure et des trous métallisés (3), qui relient entre elles des pistés conductrices de couches de transmission de signaux intérieures différentes et qui vont jusque dans la couche (2) de blindage extérieure, de laquelle ils sont isolés par exemple par des parties (4) mises à nu par attaque chimique, les trous métallisés (3) étant concentrés dans des zones délimitées de la carte (1) à circuit imprimé et ces zones pouvant être recouvertes par des dispositifs de blindage,
caractérisée en ce que
au moins des trous métallisés (3) conduisant les hautes fréquences sont concentrés par groupes sur les champs délimités, la carte (1) à circuit imprimé est sous forme d'une carte de câblage de paroi arrière d'un cadre de module, sur laquelle des connecteurs (7,8) arrière pour des connecteurs de câble enfichable sont mis en place, les connecteurs de câbles sont entourés par un boîtier de blindage, les connecteurs (7,8) sont entourés par des tôles (10) de blindage latérales, qui peuvent être mises en contact avec la couche (2) de blindage et avec le boîtier de blindage et au moins un certain nombre des trous (3) métallisés est disposé entre les pièces (7) de contact d'enfichage du connecteur et les tôles (10) de blindage ou sous ces tôles de blindage.

2. Carte à circuit imprimé suivant la revendication 1,
caractérisée en ce que
les tôles (10) de blindage peuvent être enfoncées par des saillies (6) du type broche dans des perçages de la carte (1) à circuit imprimé et les trous métallisés (3) sont disposés entre celles-ci.

3. Carte à circuit imprimé suivant la revendication 1 ou 2,
caractérisée en ce que
des rangées, se trouvant entre les pièces (7) de contact à enfichage et les tôles (10) de blindage, de points de réseau de la carte (1) à circuit imprimé sont occupées de manière ininterrompue par les trous métallisés (3).
